(19) **Europäisches Patentamt**
**European Patent Office**
**Office européen des brevets**

(11) **EP 4 585 943 A1**

(12) # EUROPEAN PATENT APPLICATION

(43) Date of publication:
**16.07.2025 Bulletin 2025/29**

(21) Application number: **24151354.8**

(22) Date of filing: **11.01.2024**

(51) International Patent Classification (IPC):
***G01R 31/367*** (2019.01) ***G01R 31/396*** (2019.01)

(52) Cooperative Patent Classification (CPC):
**G01R 31/367; G01R 31/396**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Volvo Car Corporation**
**405 31 Göteborg (SE)**

(72) Inventors:
- **Fridholm, Björn**
  **41462 Göteborg (SE)**
- **Hatefi, Arash**
  **Concord, 94521 (US)**

(74) Representative: **Nederlandsch Octrooibureau**
**P.O. Box 29720**
**2502 LS The Hague (NL)**

(54) **ADVANCED FAULT DETECTION IN BATTERY CELLS**

(57) A method for detecting faults in cells (e.g., lithium-ion battery cells) comprises monitoring one or more behaviour characteristics of a plurality of cells over time; and raising a fault alert when the following is detected: a cell with a behaviour characteristic outside a threshold range when compared with the behaviour characteristics of others of the plurality of cells.

## Description

## TECHNICAL FIELD

The present disclosure relates to monitoring and fault detection in battery cells, for example, in traction batteries used for propulsion in electric vehicles.

## BACKGROUND OF THE INVENTION

Efforts have been made to improve performance of the traction battery in vehicles through a Battery Management System ("BMS)", for example, detecting faults in connections, sensors, etc. However, faults can also happen inside cells. Such faults can be due to many different causes, for example, production defects or incorrect usage, and may lead to internal short circuit events that could result in a catastrophic failure of a battery. Therefore, it is important to detect faulty cells before they turn catastrophic.

The methods for this detection mainly fall into two categories: model-based and non-model-based methods. They differ in the extent to which they rely on accessing a model of the battery's behavior. Model-based approaches are often simple and can be cost-effective, but their accuracy depends on the fidelity of the model, which may be limited due to the complex characteristics of many batteries, including lithium-ion batteries.

Non-model-based methods do not require a physical model to function. Machine learning (ML) methods fall into this category, and have shown promising results in improving the safety, performance, and reliability of battery systems. Their ability to deal with uncertainties and learn the dynamics of complex systems, such as lithium-ion cells, has helped them to overtake classic data-driven methods, like signal processing approaches, in academic literature. However, it is important to note that, like most other data-driven methods, ML algorithms mostly disregard all the prior knowledge on the battery physics. Additionally, sometimes these algorithms heavily rely on data from the entire birth-to-death lifespan of cells to learn the underlying dynamics, which is typically not feasible to collect. Alternatively, such models rely on data from faulty cells, which is not available in a large scale due to the scarcity of most cell faults.

The diversity of faults in cells, coupled with their unknown development mechanisms poses challenges in detecting faults based on specific symptoms from current data. The prior art methods of detecting faults either rely on inaccurate modelling (which is too simple for the complex characteristics of LIBs) or computational complexity and large amounts of data which are not readily available. Thus, a better method for detecting faults in battery cells, and using that for taking appropriate actions is desired.

## SUMMARY

According to a first aspect, a method for detecting faults in cells comprises monitoring one or more behaviour characteristics of a plurality of cells over time; and raising a fault alert when the following is detected: a cell with a behaviour characteristic outside a threshold range when compared with the behaviour characteristics of others of the plurality of cells. Such a method allows for monitoring and detecting faults in cells without the need to have large past data sets or rely on inaccurate modelling. Instead, the method monitors behaviour characteristics of the cells and raises a fault alert when one cell exceeds a threshold, for example, which is determined by the average and spread of cell behaviour characteristics in the plurality of cells.

According to an embodiment, the behaviour characteristics monitored comprise one or more of: voltage measurements and current measurements. Such measurements can be easily obtained, for example, by sensors and used in the current methods to determine whether a fault alert should be raised.

According to an embodiment, the step of monitoring one or more behaviour characteristics of each of a plurality of cells over time comprises identifying a frequency response of each of the cells at a specific frequency of interest; and identifying outliers. Optionally, the method is performed over a range of frequencies, assuming a multivariate normal distribution. Such monitoring the frequency response of each of the cells at one or more specific frequencies of interest allows for monitoring and therefore identifying any outliers indicating faults or irregularities in cells. Detecting the frequencies of interest depends on the type of the cell in use. However, general frequencies that are better indicators of faults can be chosen, which can be obtained through experiments on specific cells and/or past data.

According to an embodiment, the step of identifying outliers at a single frequency of interest comprises assuming a normal distribution for cell frequency responses within the plurality of cells and finding the mean of the cell responses and standard deviation of the cell responses, followed by calculating the t-statistics for each of the cell responses. Optionally, the mean approximation instead uses the median of cell responses. This could make it is less vulnerable to outliers. The same also applies to the approximation of the standard division by using alternative approaches. The outlier detection process can then be conducted by comparing each of the t-statistics with a fixed threshold calculated by considering an arbitrary significance level and isolating the cell responses with likelihood lower than the threshold. A similar approach could be taken when dealing with multiple frequencies of interest. However, in that case the underlying distribution can be considered as a multivariate normal distribution and the outlier detection can be done by use of the Hotelling's T2 distribution. Using such a method allows for accurately identifying the outliers through a comparison with the behaviour of other cells, thereby indicating any individual faulty cells before they could potentially turn hazardous and without the need of large datasets or inaccurate modelling (of prior art methods).

According to an embodiment, when an outlier is identified, the outlier is deemed to be a cell with a behaviour characteristic outside a threshold range when compared with the behaviour characteristics of the others of the plurality of cells. Optionally, the step of raising a fault alert according to the outlier is then performed. Such an alert can be a visual, auditory, haptic or any other kind of alert to indicate to the driver/user and/or to a service provider or service center that there is an outlier that should be inspected and may need possible maintenance or replacement. Such an identification and alert helps to ensure that appropriate actions are taken when there is a potential fault, for example, that the driver knows to proceed to an inspection and/or repair point. Additionally, reporting such information and/or alert to a service provider can result in the collection of more data regarding the systems workings and maintenance or replacement needs.

According to an embodiment, the plurality of cells are in a plurality of groups of cells, for example, groups of cells within a modular battery pack. In such a case, one can assume the deviations within each group have a similar underlying distribution. Therefore, each group is centred separately using its approximate mean, and the resulting values for all individual cells are considered for the next steps, as previously described. This can be beneficial when, for example, a module is damaged and replaced with a new one, which then has a different behaviour from others. However, regardless of their excitation history, modules are expected to have roughly the same variations within their internal cells' behaviours. Therefore, the assumption is that if we subtract the average cell response in each module from the cell responses, the residual values for all of the cells must have the same distribution.

According to an embodiment, the step of identifying a frequency response of each of the cells at a specific frequency of interest comprises obtaining a plurality of voltage and current readings over a time interval from the cell; applying the Fourier transform to the plurality of voltage readings to identify a magnitude of the existing frequency component defined as obtained values for voltages; applying the Fourier transform to the plurality of current readings to identify a magnitude of the existing frequency component defined as obtained values for currents; and calculating a ratio between obtained values for voltages and obtained value for currents to find the frequency response of the cell at the specific frequency. Such a method can treat each cell as a control system with current as an input and voltage as an output. Such a method allows for monitoring cells and then identifying whether one or more is an outlier and inspection, maintenance and/or replacement is needed.

According to an embodiment, the method of identifying a frequency response of each of the cells at a specific frequency of interest is performed by conducting the above described method a plurality of times over different time intervals and combining the results. If the obtained value for current is less than a threshold (e.g., small or close to zero), the resulting cell response at that time interval is discarded (as the presence of the small number in the denominator while calculating the cell response can result is undesired numerical errors). The calculated responses at each interval can then be combined together, for example, by simply averaging the values. It is also important to take into account non-stationery and time-varying characteristic of cells through time, which implies the more recent iterations contain more accurate estimations of current gain of the cell. Therefore, in some embodiments, a weighted average can be used, which assigns a bigger weight to the more recent samples and a smaller weight to the distant ones. By performing multiple times over multiple time intervals and combining frequency responses using a weighted average, more accurate detection and identification of outliers can be made, particularly at an early stage.

According to a further aspect, a system comprises a battery comprising a plurality of cells; and a battery management system configured to perform any of the methods herein described. The battery can be, for example, a lithium-ion battery with a plurality of lithium-ion cells. Optionally, the battery management system can be in or part of a vehicle. Such a battery management system can more easily and earlier detect any irregular or outlier cells by monitoring the voltage and current and using frequency-domain analysis to identify the cell response at specific frequencies of interest. Assuming that cells within a healthy module or group should behave very similarly, the methods use the obtained cell responses to determine if any cells are statistical outliers, thereby allowing for detecting irregularities and alerting to a possible fault at an early stage by the battery management system. Thus, the system (and possible vehicle) can better and earlier detect, inspect and fix any possible irregularities in cells.

The person skilled in the art will understand that the features described above may be combined in any way deemed useful. Moreover, modifications and variations described in respect of the system may likewise be applied to a method.

## BRIEF DESCRIPTION OF THE DRAWINGS

In the following, aspects of the invention will be elucidated by means of examples, with reference to the drawings.

FIG. 1A illustrates a schematic diagram of vehicle with a battery management system;

FIG. 1B illustrates a schematic diagram of a battery with a plurality of modules each formed of a plurality of cells;

FIG. 1C illustrates a schematic depiction of a Battery Management system in communication with related systems; and

FIG. 2 illustrates a schematic flowchart of a method for detecting faults in a cell or group of cells.

## DESCRIPTION

Embodiments of the present disclosure will be described herein below with reference to the accompanying drawings. However, the embodiments of the present disclosure are not limited to the specific embodiments and should be construed as including all modifications, changes, equivalent devices and methods, and/or alternative embodiments of the present disclosure.

The terms such as "first" and "second" as used herein may modify various elements regardless of an order and/or importance of the corresponding elements, and do not limit the corresponding elements. These terms may be used for the purpose of distinguishing one element from another element. For example, a first element may be referred to as a second element without departing from the scope the present invention, and similarly, a second element may be referred to as a first element.

The terms used in describing the various embodiments of the present disclosure are for the purpose of describing particular embodiments and are not intended to limit the present disclosure. As used herein, the singular forms are intended to include the plural forms as well, unless the context clearly indicates otherwise. All of the terms used herein including technical or scientific terms have the same meanings as those generally understood by an ordinary skilled person in the related art unless they are defined otherwise. The terms defined in a generally used dictionary should be interpreted as having the same or similar meanings as the contextual meanings of the relevant technology and should not be interpreted as having ideal or exaggerated meanings unless they are clearly defined herein. According to circumstances, even the terms defined in this disclosure should not be interpreted as excluding the embodiments of the present disclosure.

The term "vehicle" as used herein refers to a thing used for transporting people or goods. Automobiles, cars, trucks, or buses etc. are examples of vehicles. The term "electric vehicle (EV)" as used herein refers to a vehicle , powered by an electric motor that draws current from an on-vehicle energy storage device, such as a battery, which is rechargeable from an off-vehicle source, such as residential or public electric service or an on-vehicle fuel powered generator. The EV may be two or more wheeled vehicles manufactured for use primarily on public streets, roads. The EV may be referred to as an electric car, an electric automobile, an electric road vehicle (ERV), a plug-in vehicle (PV), a plug-in vehicle (xEV), etc., and the xEV may be classified into a plug-in all-electric vehicle (BEV), a battery electric vehicle, a plug-in electric vehicle (PEV), a hybrid electric vehicle (HEV), a hybrid plug-in electric vehicle (HPEV), a plug-in hybrid electric vehicle (PHEV), etc.

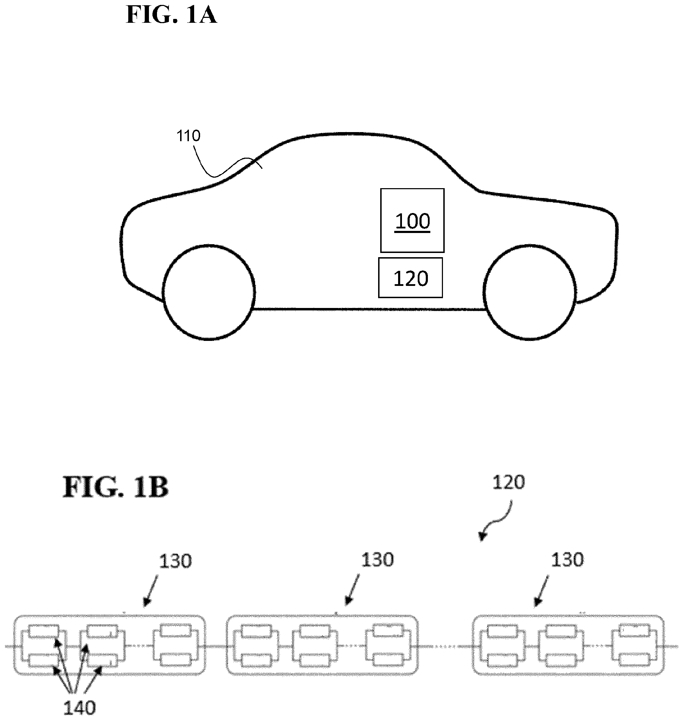

FIG. 1A shows a vehicle 110 with a battery management system 100 for managing battery 120, and Figure 1B shows a schematic view of battery 120 with a plurality of modules 130, each module 130 formed of a plurality of cells 140 grouped together to form the module 130. As can be seen in FIG. 1B, the modules 130 are then connected to each other. While three modules 130 are depicted, battery 120 could be formed by any number of modules 130, and similarly, the depiction of the number of cells 140 in each module 130 is for example purposes only and could vary. Furthermore, the existence of modules is optional, and some embodiments could have no modules, just a plurality of cells. While Fig. 1A shows a vehicle 110, battery management system 100 could be used or associated with another battery system not associated with a vehicle but formed of a plurality of battery cells, for example, for other electrical storage system such as battery packs for stationary energy storage applications.

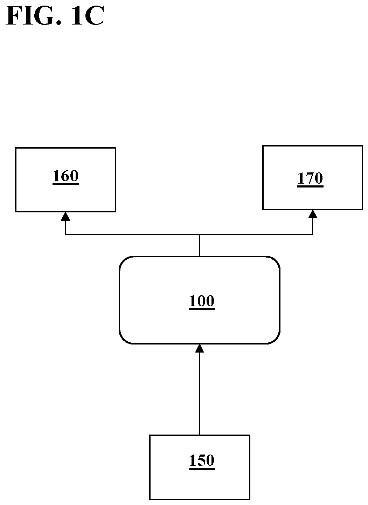

Battery management system 100, shown schematically in Figure 1C, can comprise a control unit with processors and/or any other components needed to perform method 200 for detecting faults in a cell or group of cells. One or more sensors 150 can send signals to battery management system 100, for example, voltage and/or current signals from the plurality of cells 140. Battery management system 100 then can communicate to give a driver or user of the vehicle 110 an alert or information, for example, on a user interface 160 (and/or could be audibly or haptically communicated). Battery management system 100 can also communicate with a service centre 170 or other vehicle control centre to communicate information about the battery 120.

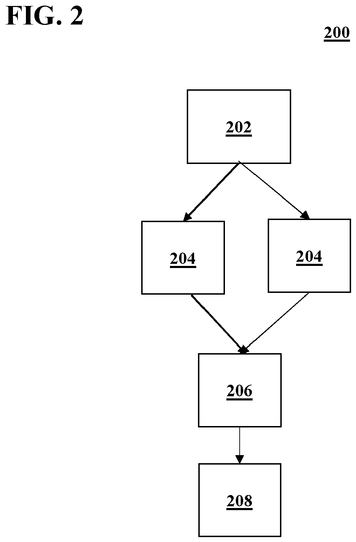

Method 200, shown in Figure 2 as a schematic flowchart provides a method for detecting faults or irregularities in battery 100 cells 140, which could be lithium-ion battery cells or other types of cells.

Method 200 starts with step 202 of monitoring one or more behavior characteristics of the cells over time. This can be through monitoring voltage and/or current of each cell over time, though in this example both voltage and current are monitored. The monitoring can be by sensors 150, which communicate with battery management system 100, to monitor the voltage and current.

This monitoring can then involve identifying a frequency response of each of the cells at one or more specific frequencies of interest, step 204. The identification of a frequency response can involve taking the plurality of voltage and current readings over a time interval from the cell and applying the Fourier transform to the plurality of voltage readings to identify a magnitude of the existing frequency component defined as obtained values for voltages; as well as applying the Fourier transform to the plurality of current readings to identify a magnitude of the existing frequency component defined as obtained values for currents. Then a ratio between obtained values for voltages and obtained value for currents is calculated to find the frequency response of the cell at the specific frequency.

For example, each cell 140 could be viewed or treated as a control system with current as an input and voltage as an output. In example cell 140, consider two voltage and current discrete sequences, denoted as $v[k]$ and $i[k]$ ($k = 0, ..., N_k$).

Using $\mathcal{G}(\omega)$ as the magnitude of the frequency response of the cell at frequency $\omega$, an approximation to $\mathcal{G}(\omega)$ based on the measurements in the timespan can be made using the following formula:

$$\hat{\mathcal{G}}(\omega) = \frac{|\mathcal{V}(\omega)|}{|\mathcal{I}(\omega)|}$$

where $v(\omega)$ and $\mathcal{I}(\omega)$ are the Discrete Fourier transform of voltages and currents at frequency. Additionally, the elements of vector $\boldsymbol{\mathcal{G}}$ can represent estimations of $\mathcal{G}(\omega)$ for $N_\omega$ distinct frequencies ($\boldsymbol{\mathcal{G}} \in \mathbb{R}^{N_\omega}$). Generally, bold letters represent vectors in the formulas provided.

This estimation can be iteratively updated, which can improve the accuracy of the estimation and consider the time-variant characteristic of cells. Similarly, the vector can be built up of several responses at different frequencies. Therefore, calculating the elements is possible via applying the described method for specific frequencies under study.

Updating $\boldsymbol{\mathcal{G}}$, can be done using the following recursive formula:

$$\boldsymbol{\mathcal{G}}[k] = \boldsymbol{\mathcal{G}}[k-1] + \boldsymbol{\eta}[k] \odot \mathbb{M}[k] \odot \left(\widehat{\boldsymbol{\mathcal{G}}}[k] - \boldsymbol{\mathcal{G}}[k-1]\right),$$

where:

- $\widehat{\boldsymbol{\mathcal{G}}}$ is the new cell frequency estimation using the latest $N_k$ voltage and current values, with its elements being the values of $\widehat{\boldsymbol{\mathcal{G}}}$ for $N_\omega$ distinct frequencies. Letting $\mathcal{V}[k] \in \mathbb{R}^{N_\omega}$ and $\mathcal{I}[k] \in \mathbb{R}^{N_\omega}$ contain the local frequency contents of the voltage and current measurements at the studied frequencies at time step k. Then, $\widehat{\boldsymbol{\mathcal{G}}}$ can be defined as

$$\widehat{\mathcal{G}}[k] = |\mathcal{V}[k]| \oslash |\mathcal{I}[k]|$$

with $\oslash$ denoting the elementwise division.

- $\eta$ is a learning rate vector which can be either fixed, or adaptive, for example, using an adaptive learning rate with an updating formula governed by an algebraic Riccati equation, though other techniques can work as well. The elements of $\eta$ are bounded between 0 and 1 and indicate the amount of weight given to the most recent estimation versus the last ones.

- $\mathbb{M}$ is a binary mask with its pth element denoted as $\mathbb{M}_p$ defined as

$$\mathbb{M}_p = \begin{cases} 1 & |\mathcal{I}_p| > L, \\ 0 & \text{otherwise,} \end{cases}$$

with L being a threshold close to zero. The existence of $\mathbb{M}$ prevents updating $\boldsymbol{\mathcal{G}}$ with new approximations on frequencies at which the cell is not being exited. In other words, if $|\mathcal{I}_p| \sim 0$, $\widehat{\mathcal{G}}_p$ may involve numerical errors due to the small denominator, it will not be used for updating $\boldsymbol{\mathcal{G}}$ and can be thus discarded.

Such a technique can be done to each cell 140 in the group (illustrated in FIG. 2 as two cells each going through step 204 simultaneously). Then step 206 can be performed to identify outliers by detecting a cell with a behaviour characteristic outside a threshold range when compared with the behaviour characteristics of others of the plurality of cells.

Step 206 can involve calculating an average module response to detect outliers within the plurality of cells. Optionally, the cells can exist in the form of N groups, each group consisting of M cells. These groups can also be referred to as modules in electric vehicle traction batteries. If no grouping exists, N can simply be considered as one in the upcoming formulas. The core assumption is that cell frequency response variations within each group belong to a single normal distribution. Therefore, the responses calculated for each cell can be subtracted from the average responses in the group, and statistical analysis (e.g., t-statistics for single under study frequency and Hotelling's T2 statistics for multiple frequencies) in combination with an arbitrary significance level can be conducted on the resulting values for all cells.

As an example, let $G_{ij}$ denote the response vector for cell $j$ in group $i$, the average group response can be calculated as:

$$\overline{G}_i = \frac{1}{M} \sum_{j=1}^{M} G_{ij}$$

Also, the centered cell response can be defined as

$$\widetilde{G}_{ij} = G_{ij} - \overline{G}_i$$

Assuming a zero-mean multi-variate normal distribution for $\widetilde{G}_{ij}$, the approximate Mahalanobis distance for cell $j$ in group $i$ can be obtained as

$$d^2 = \widetilde{G}_{ij}^{T} S^{-1} \widetilde{G}_{ij}$$

with S being the sample set covariance matrix for data from cells within the pack:

$$S^{-1} = \frac{1}{MN-1} \sum_{i=1}^{N} \sum_{j=1}^{M} G_{ij} G_{ij}^T$$

To determine the faultiness of each cell in the proposed context, one can use the control limits of the Hotelling's T$^2$ distribution, obtained as

$$J_\alpha = \frac{N_\omega((NM)^2 - 1)}{NM(NM - N_\omega)} \mathcal{F}_\alpha(N_\omega, NM - N_\omega)$$

with $\mathcal{F}_\alpha$ ($N_\omega$, $NM - N_\omega$) being the lower $\alpha$ percentile of the $\mathcal{F}$ distribution with $N_\omega$ and $NM - N_\omega$ degrees of freedom. Exceeding the formatted threshold is an indication of a fault in the corresponding cell with a false positive rate of a.

Optionally, it is also possible to consider cells from different battery packs simultaneously in the calculation of $J_\alpha$. This requires two main conditions to be satisfied: Firstly, the cells within distinct battery packs need to have roughly the same age and charge/discharge history, and secondly, they need to be at a similar state of charge and other environmental conditions while conducting the experiment. This is to ensure that the underlying characteristics of cells are as close as possible to each other and coming for a single normal distribution.

When an outlier is identified in step 206, step 208 can provide an alert. Such an alert can be a visual, auditory, haptic or any other kind of alert to indicate to the driver/user and/or to a service provider or control center that there is an outlier that should be inspected and may need possible maintenance and/or replacement. Such an alert could also indicate the possible severity and/or the urgency of the inspection for the alert. Such possible severity and/or the urgency could be related to the outlier detection and level of difference with the threshold.

In summary, method 200 allows for detection of irregular cell voltage variations over time in a battery comprising a plurality of cells. The use of frequency analysis and in particular the identification of the frequency response of each cell at one or more specific frequencies of interest and identifying outliers from that distribution provides an effective method to detect and identify potential faults in cells by comparing changing behaviour with the changing behaviour of other cells. The method is not vulnerable to natural variations in individual cells over time for example during charge/discharge cycles as the whole population of the cells undergo such changes. Also, the methods do not explicitly depend on underlying physical models of the cell, or require massive birth to death datasets from batteries. Last but not least, the reliance of the methods on Fast Fourier transform (FFT) makes it extremely computationally efficient as FFT is among the most mature algorithms, and even some CPUs have explicit hardware support for performing it. Thus, such a method allows for use of real-time information from sensors and the battery management system to detect faults, allowing for appropriate alerts to be performed and/or actions to be taken at an earlier stage, making for an overall better experience for the user and possibly detecting issues in cells before they become catastrophic.

Those skilled in the art will appreciate that the methods, systems and components described herein may comprise, in whole or in part, a combination of analog and digital circuits and/or one or more appropriately programmed processors (e.g., one or more microprocessors including central processing units (CPU)) and associated memory, which may include stored operating system software, firmware and/or application software executable by the processor(s) for controlling operation thereof and/or for performing the particular algorithms represented by the various functions and/or operations described herein, including interaction between and/or cooperation with each other as well as transmitters and receivers. One or more of such processors, as well as other digital hardware, may be included in a single ASIC (Application-Specific Integrated Circuitry), or several processors and various digital hardware may be distributed among several separate components, whether individually packaged or assembled into a SoC (System-on-a-Chip).

Furthermore, the systems, methods and components described, and/or any other arrangement, unit, system, device or module described herein may for instance be implemented in one or several arbitrary nodes comprised in the vehicle and/or one or more separate devices or systems. In that regard, such a node may comprise a control unit or any suitable electronic device, which may be a main or central node. It should also be noted that the these may further comprise or be arranged or configured to cooperate with any type of storage device or storage arrangement known in the art, which may for example be used for storing input or output data associated with the functions and/or operations described herein. The systems, components and methods described herein may further comprise any computer hardware and software and/or electrical hardware known in the art configured to enable communication therebetween.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

**Claims**

1. A method for detecting faults in cells (140), the method comprising:

   monitoring one or more behaviour characteristics of a plurality of cells over time; and
   raising a fault alert when the following is detected:
   a cell with a behaviour characteristic outside a threshold range when compared with the behaviour characteristics of others of the plurality of cells.

2. The method of claim 1, wherein the behaviour characteristics monitored comprise one or more of: voltage measurements and current measurements.

3. The method of any of claims 1-2, wherein the step of monitoring one or more behaviour characteristics of each of a plurality of cells over time comprises:

   identifying a frequency response of each of the cells at a specific frequency of interest; and
   identifying outliers.

4. The method of claim 3, wherein the step of identifying outliers comprises:

assuming a normal distribution for cell frequency responses within the plurality of cells,
finding a mean and standard deviation of the cell responses for the plurality of cells; and
calculating the t-statistics for each of the cell responses, and
identifying outliers in the distribution.

5. The method of claim 4, wherein the step of identifying outliers comprises comparing each of the t-statistics and filtering out any points with likelihood lower than a specified threshold, associated with an arbitrary significance level.

6. The method of any of claims 3-5, wherein, assuming a multivariate normal distribution, the method is performed with a range of frequencies of interest.

7. The method of claim 6, wherein the method used for identifying outliers is Hotelling's T2 distribution.

8. The method of any of claims 4-7, wherein when an outlier is identified, the outlier is deemed to be a cell with a behaviour characteristic outside a threshold range when compared with the behaviour characteristics of the others of the plurality of cells.

9. The method of claim 8, wherein the step of raising a fault alert according to the outlier is then performed.

10. The method of any of the preceding claims, wherein the plurality of cells are in a plurality of groups of cells,

    wherein an average group response is calculated and each group is centred with the average group response, and the resulting values from all groups are considered to be of a single distribution, and
    wherein the step of identifying outliers comprises identifying cells with outlier values with respect to the single distribution.

11. The method of claim 10, wherein each of the groups is a module.

12. The method of any of claims 3-11, wherein the step of identifying a frequency response of each of the cells at a specific frequency of interest comprises:

    obtaining a plurality of voltage and current readings over a time interval from the cell;
    applying the Fourier transform to the plurality of voltage readings to identify a magnitude of the existing frequency component defined as obtained values for voltages;
    applying the Fourier transform to the plurality of current readings to identify a magnitude of the existing frequency component defined as obtained values for currents; and
    calculating a ratio between obtained values for voltages and obtained value for currents to find the frequency response of the cell at the specific frequency,
    wherein each cell comprises a control system with current as an input and voltage as an output.

13. The method of claim 12, wherein the method of identifying a frequency response of each of the cells at a specific frequency of interest is performed by conducting the method of claim 12 a plurality of times over a plurality of time intervals and combining the results, and wherein the method comprises combining frequency responses calculated in different time intervals using a weighted average of the calculated values to approximate the actual value.

14. A system comprising:

    a battery (120) comprising a plurality of cells (140);
    a battery management system (100) configured to perform the method of any of the preceding claims.

15. A vehicle (110) or stationary energy storage comprising the system of claim 14.

## FIG. 1A

110

100

120

## FIG. 1B

120

130

130

130

140

# FIG. 1C

160

170

100

150

# FIG. 2

<u>200</u>

Europäisches
Patentamt

European
Patent Office

Office européen
des brevets

# EUROPEAN SEARCH REPORT

Application Number

EP 24 15 1354

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/366935 A1 (LEE SUN-JONG [KR] ET AL) 16 November 2023 (2023-11-16) | 1-3,14, 15 | INV. G01R31/367 G01R31/396 |
| A | * paragraph [0041] - paragraph [0097]; claims 1-15; figure 1 * | 4-13 | |
| A | LIEBHART BERNHARD ET AL: "Application of nonlinear impedance spectroscopy for the diagnosis of lithium-ion battery cells under various operating conditions", JOURNAL OF POWER SOURCES, ELSEVIER, AMSTERDAM, NL, vol. 480, 29 September 2020 (2020-09-29), XP086351022, ISSN: 0378-7753, DOI: 10.1016/J.JPOWSOUR.2020.228673 [retrieved on 2020-09-29] * the whole document * | 3 | |
| X | US 2023/152388 A1 (SUNG YONG-CHUL [KR] ET AL) 18 May 2023 (2023-05-18) | 1-3,14, 15 | |
| A | * paragraph [0048] - paragraph [0168] * | 4-13 | **TECHNICAL FIELDS SEARCHED (IPC)** |
| X | US 2022/140617 A1 (WANG YUE-YUN [US] ET AL) 5 May 2022 (2022-05-05) | 1-3,14, 15 | G01R |
| A | * paragraph [0035] - paragraph [0054]; claims 1, 2 * | 4-13 | |
| X | US 2022/376314 A1 (KOCH SEBASTIAN [DE] ET AL) 24 November 2022 (2022-11-24) | 1-3,14, 15 | |
| A | * paragraph [0043] - paragraph [0055]; claims 1-3 * | 4-13 | |

The present search report has been drawn up for all claims

| Place of search | Date of completion of the search | Examiner |
|---|---|---|
| Munich | 27 June 2024 | Meggyesi, Zoltán |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**EP 4 585 943 A1**

## ANNEX TO THE EUROPEAN SEARCH REPORT
## ON EUROPEAN PATENT APPLICATION NO.

EP 24 15 1354

This annex lists the patent family members relating to the patent documents cited in the above-mentioned European search report.
The members are as contained in the European Patent Office EDP file on
The European Patent Office is in no way liable for these particulars which are merely given for the purpose of information.

27-06-2024

| Patent document cited in search report | | Publication date | Patent family member(s) | | Publication date |
|---|---|---|---|---|---|
| US 2023366935 | A1 | 16-11-2023 | CN | 116324449 A | 23-06-2023 |
| | | | EP | 4206713 A1 | 05-07-2023 |
| | | | JP | 7498358 B2 | 11-06-2024 |
| | | | JP | 2023538347 A | 07-09-2023 |
| | | | KR | 20230010545 A | 19-01-2023 |
| | | | US | 2023366935 A1 | 16-11-2023 |
| | | | WO | 2023287180 A1 | 19-01-2023 |
| US 2023152388 | A1 | 18-05-2023 | CN | 115461634 A | 09-12-2022 |
| | | | EP | 4152021 A1 | 22-03-2023 |
| | | | JP | 7483922 B2 | 15-05-2024 |
| | | | JP | 2023519949 A | 15-05-2023 |
| | | | KR | 20220074797 A | 03-06-2022 |
| | | | US | 2023152388 A1 | 18-05-2023 |
| | | | US | 2023243895 A1 | 03-08-2023 |
| | | | WO | 2022114871 A1 | 02-06-2022 |
| US 2022140617 | A1 | 05-05-2022 | CN | 114441979 A | 06-05-2022 |
| | | | DE | 102021110152 A1 | 05-05-2022 |
| | | | US | 2022140617 A1 | 05-05-2022 |
| US 2022376314 | A1 | 24-11-2022 | CN | 115372854 A | 22-11-2022 |
| | | | DE | 102021113211 A1 | 24-11-2022 |
| | | | US | 2022376314 A1 | 24-11-2022 |

EPO FORM P0459

For more details about this annex : see Official Journal of the European Patent Office, No. 12/82